Europäisches Patentamt

European Patent Office

Office européen des brevets

(19)

(11) **EP 0 674 771 B1**

(12) **FASCICULE DE BREVET EUROPEEN**

(45) Date de publication et mention
de la délivrance du brevet:
**05.03.1997 Bulletin 1997/10**

(21) Numéro de dépôt: **94902823.7**

(22) Date de dépôt: **16.12.1993**

(51) Int Cl.$^6$: **G01R 33/12**

(86) Numéro de dépôt international:
**PCT/FR93/01257**

**WO 94/14080 (23.06.1994 Gazette 1994/14)**

(54) **PROCEDE DE DETERMINATION DE LA PERMEABILITE MAGNETIQUE INTRINSEQUE D'ELEMENTS FERROMAGNETIQUES ALLONGES**

**VERFAHREN ZUR BESTIMMUNG VON INTRINSIEKEN MAGNETISCHEN PERMEABILITÄT VON LANGGESTRECKTEN FERROMAGNETISCHEN ELEMENTEN**

**PROCESS FOR DETERMINATION OF THE INTRINSIC MAGNETIC PERMEABILITY OF OBLONG FERROMAGNETIC ELEMENTS**

(84) Etats contractants désignés:
**DE FR GB IT NL**

(30) Priorité: **17.12.1992 FR 9215234**

(43) Date de publication de la demande:
**04.10.1995 Bulletin 1995/40**

(73) Titulaire: **COMMISSARIAT A L'ENERGIE ATOMIQUE**
**75752 Paris Cédex 15 (FR)**

(72) Inventeurs:
- **ACHER, Olivier 16, résidence Petit-Chambord F-92340 Bourg-la-Reine (FR)**
- **JACQUART, Pierre, Marie Bâtiment 3 F-77680 Roissy-en-Brie (FR)**
- **SCHAAL, Alfred F-91300 Massy (FR)**

(74) Mandataire: **Signore, Robert et al**
**c/o BREVATOME**
**25, rue de Ponthieu**
**75008 Paris (FR)**

(56) Documents cités:
EP-A- 0 299 498          WO-A-91/12960
DE-A- 2 913 741          FR-A- 2 550 628
US-A- 3 553 622

- **IEEE TRANSACTIONS ON INSTRUMENTATION AND MEASUREMENT, vol.IM-23, no.4, Décembre 1974, NEW YORK US pages 425 - 431 A.C. LYNCH 'Precise Measurements on Dielectric and Magnetic Materials'**
- **IEEE TRANSACTIONS ON INSTRUMENTATION AND MEASUREMENT, vol.IM-19, no.4, Novembre 1970, NEW YORK US pages 377 - 382 A.M. NICOLSON ET AL. 'Measurement of the Intrinsic Properties of Materials by Time-Domain Techniques'**
- **ELECTRONICS LETTERS., vol.26, no.15, 19 Juillet 1990, STEVENAGE GB pages 1151 - 1153 J.C. HENAUX ET AL. 'Dimensional correction of high dielectric and magnetic constants determined by S parameters measurements'**
- **PATENT ABSTRACTS OF JAPAN vol. 16, no. 116 (E-1181) 24 Mars 1992 & JP,A,03 286 505 (MATSUSHITA ELECTRIC IND. CO.)**
- **DATABASE WPI Week 8819, Derwent Publications Ltd., London, GB; AN 88-130683 'Soft maggnetic adhesive' & JP,A,63 075 080 (RICOH KK) 5 Avril 1988**
- **JOURNAL DE PHYSIQUE IV (COLLOQUE), vol.3, Décembre 1992, FRANCE pages C3-229 - 233 O. ACHER ET AL. 'Evolution de la permeabilité haute fréquence (jusqu'à 3 GHz) de couches minces ferromagnétiques à base de cobalt en fonction de la contrainte'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

### Domaine technique

La présente invention a pour objet un procédé de détermination de la perméabilité magnétique intrinsèque d'éléments ferromagnétiques allongés et un procédé de détermination des propriétés électromagnétiques (perméabilité magnétique et permittivité électrique) pour une polarisation particulière, de composites anisotropes utilisant de tels éléments ferromagnétiques allongés.

Les éléments ferromagnétiques de l'invention sont allongés selon au moins une direction. Il peut s'agir par exemple de couches minces, de lamelles, de fibres, de fils, d'aiguilles, de plaquettes, etc...

Les composites anisotropes considérés dans l'invention sont constitués d'éléments ferromagnétiques allongés, tous orientés dans une même direction, l'ensemble étant tenu dans un isolant.

### Etat de la technique antérieure

Dans la technique des hyperfréquences, on utilise souvent, à l'intérieur d'un guide d'onde, un composant chargé de modifier la propagation de l'onde incidente. Cette "charge" peut servir par exemple à déphaser l'onde, à la réfléchir ou à l'absorber plus ou moins, sur telle ou telle gamme de fréquence.

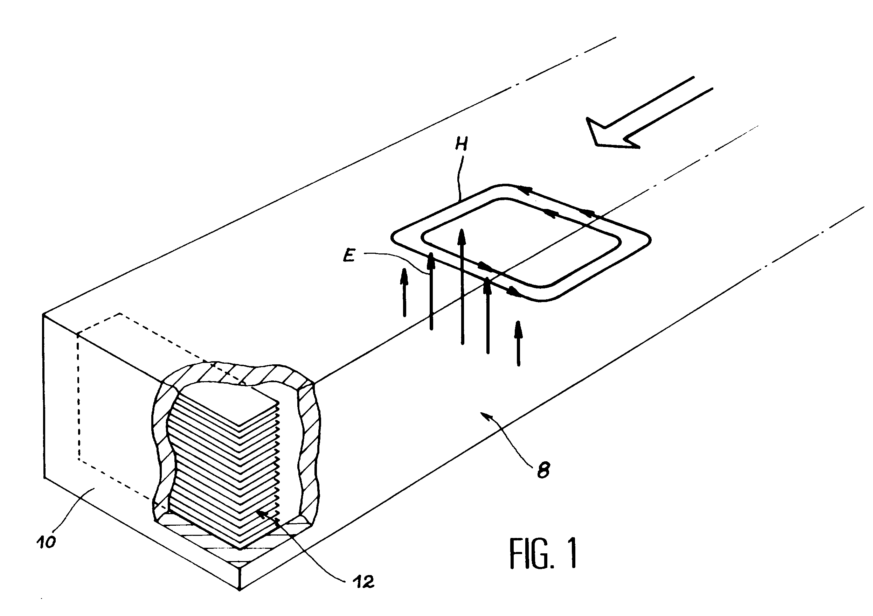

La figure 1 annexée montre ainsi un guide d'onde rectangulaire 8 muni à son extrémité 10 d'une charge 12. Cette charge peut prendre de multiples formes. Il peut s'agir notamment d'un produit composite formé d'un empilement de couches magnétiques, par exemple ferromagnétiques, et de couches isolantes alternées.

Le champ électromagnétique circulant dans un tel guide, dans le mode de propagation illustré, présente une composante électrique E verticale, donc perpendiculaire aux plans des couches, et une composante magnétique horizontale, donc dans le plan des couches.

Dans le cas d'une propagation en espace libre, le champ magnétique pourrait être dirigé perpendiculairement aux couches et le champ électrique parallèlement à celles-ci. Le composite serait alors réfléchissant.

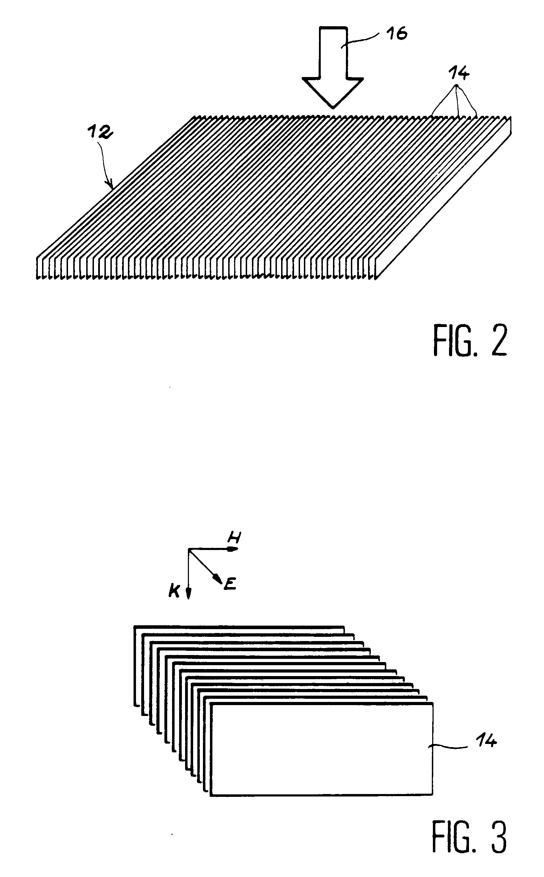

La figure 2 annexée illustre de manière simplifiée et agrandie la structure du composite en question avec sa structure lamellaire 12, recevant l'onde guidée 16. La particularité de ce composite est de présenter des couches ferromagnétiques orientées parallèlement à la direction de propagation du champ électromagnétique.

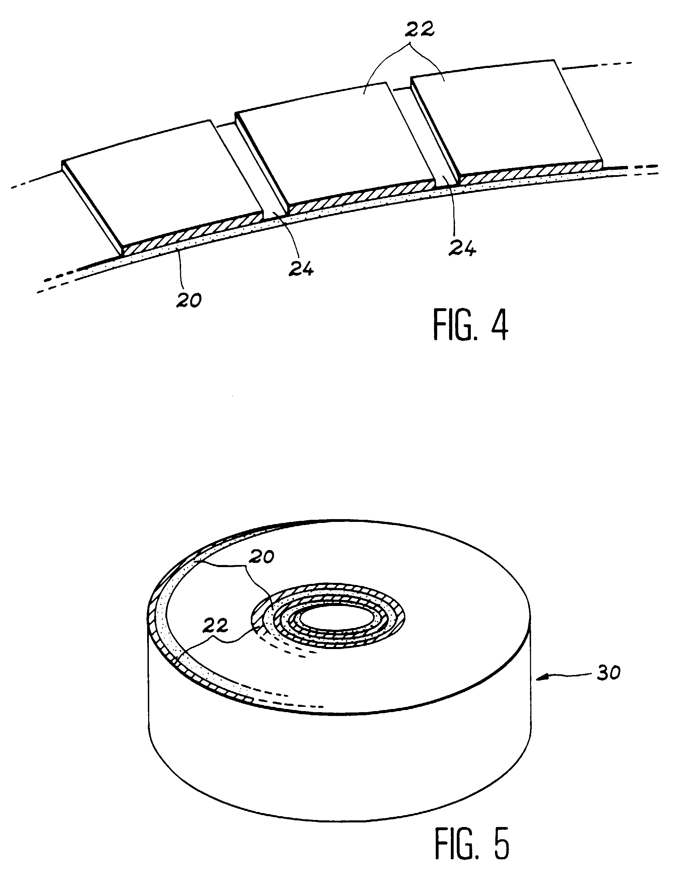

La figure 3 permet de préciser les conditions pour obtenir une meilleure pénétration ou interaction en profondeur de l'onde dans le matériau. L'onde électromagnétique doit se présenter de telle sorte que le champ magnétique H soit dans le plan des couches et le champ électrique E perpendiculaire à celles-ci. Le vecteur de propagation K est alors dirigé parallèlement aux couches et normalement à la surface libre du composite.

On sait bien ajuster les épaisseurs des charges et les agencer, pour les adapter à la fonction recherchée (déphasage, réflexion ou absorption, etc...), si l'on connaît les propriétés électromagnétiques de permittivité $\varepsilon$ et de perméabilité $\mu$ des matériaux en fonction de la fréquence. Mais la détermination de ces propriétés $\varepsilon$ et $\mu$ pour un composite anisotrope tel que celui de la figure 2 est difficile. Les techniques actuelles de détermination de $\varepsilon$ et $\mu$ d'un composite anisotrope ne sont pas susceptibles de donner ces grandeurs sur une large gamme de fréquence et nécessitent des quantités importantes de matériaux.

Dans nombre de cas, on peut prédire la perméabilité du composite à partir de la perméabilité intrinsèque du ferromagnétique. Mais cette perméabilité intrinsèque est elle aussi difficile à mesurer. Parmi les méthodes de mesure de la perméabilité magnétique d'un matériau, certaines reposent sur la mesure de l'inductance d'une bobine dans laquelle on place le matériau à mesurer. Cependant, cette méthode est limitée vers les hautes fréquences par la fréquence de résonance de la bobine. Il est très difficile de dépasser 1 GHz avec cette technique. De plus, la calibration "à vide" de la bobine peut être délicate et les effets de bords gênants.

Par ailleurs, on peut envisager la mesure directe de la perméabilité en dirigeant une onde électromagnétique sur le matériau. De telles mesures doivent permettre de remonter à la perméabilité. Cependant, cette méthode fonctionne très mal avec les matériaux conducteurs, ce que sont justement les ferromagnétiques. Une onde électromagnétique y pénètre sur une épaisseur (appelée épaisseur de peau), qui décroît avec la fréquence. A des fréquences supérieures à quelques centaines de MHz, cette épaisseur est très faible : quelques dizaines de microns, voire beaucoup moins. Il est alors pratiquement impossible de mesurer la perméabilité par des mesures de réflexion ou de transmission à travers un matériau massif, alors que cette méthode fonctionne très bien pour des matériaux ou des composites peu ou pas conducteurs.

On peut, en revanche, effectuer des mesures en cavité, en plaçant un matériau ferromagnétique sur la paroi d'une cavité résonnante. En mesurant le déplacement de la fréquence de résonance de la cavité, il est possible de déterminer la perméabilité du film à cette fréquence. Mais cette méthode présente l'inconvénient d'être monofréquence.

Le document FR-A-2 550 628 décrit un procédé selon lequel on place un échantillon toroïdal en matériau ferrimagnétique dans une ligne coaxiale, et, à l'aide d'une boucle de mesure entourant cet échantillon, on effectue des mesures qui, par comparaison avec un échantillon toroïdal en matériau non magnétique, permettant de déterminer la perméabilité du matériau.

Le document ELECTRONICS LETTERS, vol. 26, n°15, 19 juillet 1990, pages 1151 à 1153, décrit un procédé de mesure de constantes diélectriques et magnétiques d'un matériau plein présentant la forme d'un mince cylindre entourant le conducteur central d'une ligne coaxiale.

Le document IEEE Transactions on Instrumentation and Measurement, vol. IM-23, n°4, décembre 1994, pages 425-431, décrit des techniques de mesure de noyaux de transformateur à fréquence très basse.

Le document IEEE Transactions on Instrumentation and Measurements, vol. IM-19, n°4, Novembre 1970, pages 377-382 décrit une technique de mesure des propriétés intrinsèques de certains matériaux par des mesures dans le domaine temporel. On place un échantillon du matériau à mesurer dans une ligne microonde et on excite l'échantillon par une impulsion électromagnétique de durée inférieure à la nanoseconde. On mesure l'onde transmise et l'onde réfléchie et l'on déduit de la forme de celles-ci la permittivité et la perméabilité du matériau.

L'article de C.A. GRIMES et al. publié dans IEEE Trans. Magnetics, 24(1), 1988 (pp. 603) explique les limitations en fréquence des techniques de mesure de la perméabilité des matériaux ferromagnétiques et en particulier lorsqu'on a affaire à une couche mince anisotrope (qui présente une perméabilité différente dans des directions orthogonales).

Dans l'article de H. KOYAMA et al. intitulé "Permeability of CoNbZr amorphous thin films over a wide frequency range" publié dans IEEE Translation Journal of Magnetics in Japan, vol. TJMJ-2, n°9, sept. 1987), il est enseigné qu'il faut deux montages différents pour effectuer la mesure entre 1 MHz et 1,6 GHz.

La présente invention a justement pour but de remédier à tous ces inconvénients. Elle permet la détermination de la perméabilité magnétique intrinsèque d'éléments ferromagnétiques allongés (couches minces, fibres, aiguilles, plaquettes, etc...) sur une large plage de fréquence allant de 0,01 GHz à plus de 20 GHz, et cela à l'aide d'une procédure de mesure classique en hyperfréquence. Elle permet aussi la détermination des propriétés électromagnétiques de composites ferromagnétiques-isolant anisotropes où la partie ferromagnétique est constituée d'éléments ferromagnétiques allongés (couches minces, fibres, aiguilles, plaquettes, etc...) isolés les uns des autres par un isolant, et orientés dans une direction. Le procédé de l'invention permet d'obtenir la perméabilité magnétique ou la permittivité électrique recherchée sur une large plage de fréquence allant d'environ 0,01 GHz (10 MHz) à plus de 20 GHz et cela à l'aide d'une procédure de mesure classique en hyperfréquences.

Pour atteindre ces buts, selon l'invention, on commence par bobiner les éléments ferromagnétiques sous forme de tore, en les enrobant dans un matériau isolant électrique, lesdits éléments étant allongés dans le tore dans une direction tangentielle. On dispose ensuite ce tore dans une ligne coaxiale appartenant à un banc de mesure.

Or, on sait que, dans une ligne coaxiale, le mode électromagnétique fondamental qui se propage est tel que le champ électrique est radial et le champ magnétique tangentiel. Dans la ligne, le champ magnétique sera donc dirigé dans les couches ferromagnétiques du tore et le champ électrique sera perpendiculaire à ces couches. Cette configuration des champs est précisément celle qui correspond au mode qui peut pénétrer dans le matériau (cf Fig. 3). En même temps, il permet d'effectuer des mesures hyperfréquences classiques en réflexion et en transmission dans la ligne coaxiale. On pourra réaliser ces mesures à l'aide d'un analyseur de réseau classique. On obtiendra ainsi la perméabilité magnétique $u_m$ pour un champ magnétique hyperfréquence dans la direction des couches, et la permittivité électrique $\varepsilon_m$ pour un champ électrique perpendiculaire à ces couches. Ce sont ces valeurs de la perméabilité et de la permittivité qui permettent de prédire le comportement du composite pour une onde dont la polarisation est celle indiquée figure 1 ou 3 ou 11.

Ayant mesuré la perméabilité magnétique du tore, et compte tenu de la fraction de matériau ferromagnétique contenue dans le tore, on pourra ensuite déduire la perméabilité magnétique intrinsèque des éléments ferromagnétiques utilisés. On sait, en effet, d'une manière générale, que la perméabilité d'un composite stratifié étant connue, on peut remonter à la valeur de la perméabilité intrinsèque du matériau ferromagnétique qui le compose. Des travaux ont été publiés sur ce sujet, notamment par S.M. RYTOV dans "Electromagnetic Properties of a Finely Stratified Medium" publié dans Soviet Physics JETP, vol. 2, n° 3, Mai 1956, pp. 466-475. Si l'épaisseur du matériau ferromagnétique est faible devant l'épaisseur de peau à la fréquence considérée, la perméabilité du ferromagnétique $\mu_f$ est liée à la perméabilité mesurée pour le composite, soit $\mu_m$, par la relation :

$$\mu_f = 1 + (\mu_m - 1)/F$$

où F est le taux de charge en matériau ferromagnétique (cela est vrai car la perméabilité de la matrice vaut 1).

Si l'épaisseur de la couche ferromagnétique n'est plus négligeable devant l'épaisseur de peau, la relation est plus complexe et devient :

$$\mu_m = [(1-F) + F.C\mu_f]/[1 + F(C-1)]$$

avec

$$C = \frac{tg(\pi N_f e_f/\lambda)}{\pi N_f e_f/\lambda}$$

où F désigne encore le taux de charge en ferromagnétique, et où $\lambda$ est la longueur d'onde, $e_f$ l'épaisseur de la couche ferromagnétique, $N_f$ l'indice du matériau ferromagnétique (égal à la racine carrée du produit de la permittivité électrique par la perméabilité à la fréquence considérée).

On peut résoudre numériquement cette relation pour trouver $\mu_f$ en fonction de la perméabilité mesurée $\mu_m$.

On appliquera donc ces formules (ou d'autres plus complexes le cas échéant) par exemple (voir LANDAU et LIFCHITZ, Physique Théorique, tome 8, édition MIR, 2ème édition, 1990) pour remonter à la perméabilité ou la permittivité instrinsèque du matériau ferromagnétique.

Lorsque les éléments ferromagnétiques dont on veut déterminer la perméabilité sont des couches minces, on pourra former le tore de la manière suivante :

- on part d'un film isolant électriquement,
- on recouvre ce film isolant d'une couche mince de matériau ferromagnétique,
- on découpe le support isolant ainsi recouvert pour former un ruban,
- on bobine ce ruban sur lui-même.

On pourra aussi partir d'un ruban de ferromagnétique (tels que ceux produits par laminage, ou bien par la méthode de trempe sur roue), éventuellement aminci par un procédé chimique. L'isolant sera un vernis, une colle, un film souple ou bien une combinaison de l'ensemble. Si l'épaisseur de la couche ferromagnétique dépasse 10 $\mu$m, on aura avantage à l'amincir (par attaque chimique par exemple), pour avoir une meilleure précision de mesure.

La présente invention n'est cependant pas limitée au cas des couches minces. Elle peut également être mise en oeuvre avec des fils ou des fibres ferromagnétiques. Dans ce cas, pour former le tore, on bobinera un fil ferromagnétique sur une âme en enrobant l'ensemble dans un matériau isolant.

Pour constituer le fil ferromagnétique, on pourra partir d'un fil isolant sur lequel on aura déposer un matériau ferromagnétique.

On pourra aussi partir d'un film ferromagnétique massif, éventuellement gainé d'un vernis isolant.

Lorsque les éléments ferromagnétiques sont des plaquettes ou des aiguilles, on pourra former le tore de la manière suivante :

- on réalise une couche de faible épaisseur (de 20 $\mu$m à 2 mm, typiquement) de mélange ferromagnétique et liant, dans laquelle les éléments ferromagnétiques sont orientés ; cette orientation peut par exemple être provoquée par l'application d'un champ magnétique adapté ;
- on découpe des rubans dans cette couche dans des directions convenables et on les bobine pour obtenir un tore, éventuellement en rajoutant de la colle.

Cela nécessite que la couche de ferromagnétique et liant soit assez souple pour cette opération de bobinage. On aura donc recours à un liant qui reste souple après sa prise, ou bien on découpera et bobinera les rubans avant la prise totale du liant. On aura intérêt à minimiser l'épaisseur des joints de colle qui affecte essentiellement la mesure de $\varepsilon$. L'erreur relative sur la détermination de $\varepsilon$ est environ :

$$\frac{\varepsilon\,\text{mesuré} - \varepsilon\,\text{composite}}{\varepsilon\,\text{composite}} = g \times \left( 1 - \frac{\varepsilon\,\text{mesuré}}{\varepsilon\,\text{colle}} \right)$$

où g est la fraction volumique de colle ou d'addition de résine.

Pour mesurer des composites à $\varepsilon$ élevé (proche de 10 ou au-delà), on peut avoir intérêt à utiliser comme colle ou résine pour faire tenir le bobinage, une colle ou résine dont la permittivité $\varepsilon$ est proche de ou supérieure à 10, afin de limiter l'erreur.

A titre d'exemple, on peut mélanger des aiguilles ferromagnétiques allongées avec une résine (par exemple de la marque Rhône-Poulenc RTV141) avec un taux volumique de 10%, couler une plaque d'épaisseur 0,3 mm environ, orienter les aiguilles sous un champ magnétique fixe de 300 Oe durant 1/2 heure, faire prendre la résine par passage à l'étuve à 120° durant 4 h, découper des lanières dans la direction des aiguilles. Le liant proposé reste souple ; on peut donc bobiner ces lanières en tore.

On utilisera la résine RTV141 pour réaliser le collage, ou mieux la résine RTV141 chargée de ces mêmes éléments ferromagnétiques, au même taux de charge.

On réalisera l'usinage du tore aux cotes de la ligne coaxiale et on réalisera les mesures selon les procédures habituelles en ligne coaxiale.

## Brève description des dessins

- la figure 1, déjà décrite, montre un un matériau composite disposé dans un guide d'onde rectangulaire ;
- la figure 2, déjà décrite, montre la structure du composite ;
- la figure 3, déjà décrite, représente schématiquement un composite et indique la direction des champs électrique et magnétique pour obtenir une bonne pénétration de l'onde dans le composite ;
- la figure 4 montre un ruban isolant recouvert d'une couche ferromagnétique interrompue ;
- la figure 5 montre un tore obtenu en bobinant le ruban de la figure précédente ;
- la figure 6 représente schématiquement une ligne coaxiale dans laquelle a été introduit le tore de la figure précédente ;
- la figure 7 montre les lignes de champ électrique et de champ magnétique dans le tore ;
- la figure 8 montre une variante du tore à bobine et à collier diélectriques ;
- la figure 9 montre les résultats d'une mesure de perméabilité magnétique d'un composite ;
- la figure 10 illustre un autre exemple de mise en oeuvre de l'invention dans le cas de fibres ferromagnétiques ;
- la figure 11 montre l'allure générale d'un composite anisotrope à base de fibres ferromagnétiques.

## Exposé détaillé de modes de réalisation

Lorsque les éléments ferromagnétiques sont des couches minces, on peut s'y prendre comme illustré sur les figures 4 et 5 pour constituer le tore devant servir à la mesure en ligne coaxiale.

On part d'un film isolant 20, par exemple en Mylar (marque déposée) et l'on recouvre ce film d'une couche mince ferromagnétique 22, par exemple en CoNiZrMo et cela par tout moyen. On découpe ensuite ce film pour obtenir un ruban. On peut aussi partir d'une feuille ou d'un ruban mince ferromagnétique sans support, par exemple produit par la méthode de trempe sur roue, ou par laminage, et éventuellement aminci par attaque chimique ou autre. Alors, l'isolant peut être un film souple, mais aussi un vernis ou bien simplement la colle utilisée pour rendre le bobinage solide.

Si l'on bobinait tel quel le ruban avec sa couche ferromagnétique, on obtiendrait un tore avec une couche ferromagnétique d'un seul tenant, enroulée en spirale. Le tore ne serait pas alors exactement (pour le champ électromagnétique se propageant dans la ligne coaxiale) équivalent au composite lamellaire des figures 2 et 3. Pour éviter cette cause d'erreur et obtenir un tore dont la perméabilité mesurée en ligne coaxiale soit liée correctement à la perméabilité intrinsèque, sans perdre l'avantage de la géométrie bobinée, on peut réaliser des discontinuités électriques du ruban ferromagnétique. Ces discontinuités sont référencées 24 sur la figure 4. On peut les obtenir directement lors du dépôt de la couche ferromagnétique (par masquage), ou bien, après dépôt, en gravant le matériau ferromagnétique. On peut aussi étirer le film souple, de manière à craqueler le dépôt.

Il n'est pas nécessaire que ces discontinuités soient régulières. Il est préférable que les longueurs de continuité soient toutes assez faibles. On veillera notamment à ce que la distance entre deux discontinuités reste nettement supérieure à l'épaisseur de la couche.

Les discontinuités électriques ne sont pas nécessaires, d'autant moins que le ruban ferromagnétique est peu épais et pas trop conducteur, et que les fréquences auxquelles on effectue la mesure sont élevées. Typiquement, si l'épaisseur du ferromagnétique est de 0,4 $\mu$m et si la conductivité est de 135 $\mu\Omega$.cm, la mesure est très bonne à partir de 500 MHz, même sans discontinuités.

Le ruban de la figure 4 est ensuite bobiné sur un mandrin. On peut, pour garantir la bonne tenue mécanique de l'ensemble, ajouter un matériau du genre colle, résine ou vernis.

On obtient alors un tore comme illustré sur la figure 5 où il est référencé 30. On y voit la couche isolante 20 et la couche ferromagnétique 22 occuper une position tangentielle (comme déjà indiqué, ces couches ne sont pas rigoureusement tangentielles puisqu'elles forment une spirale et non des cercles concentriques ; mais ce décalage géométrique par rapport à la situation idéale est sans conséquence pratique).

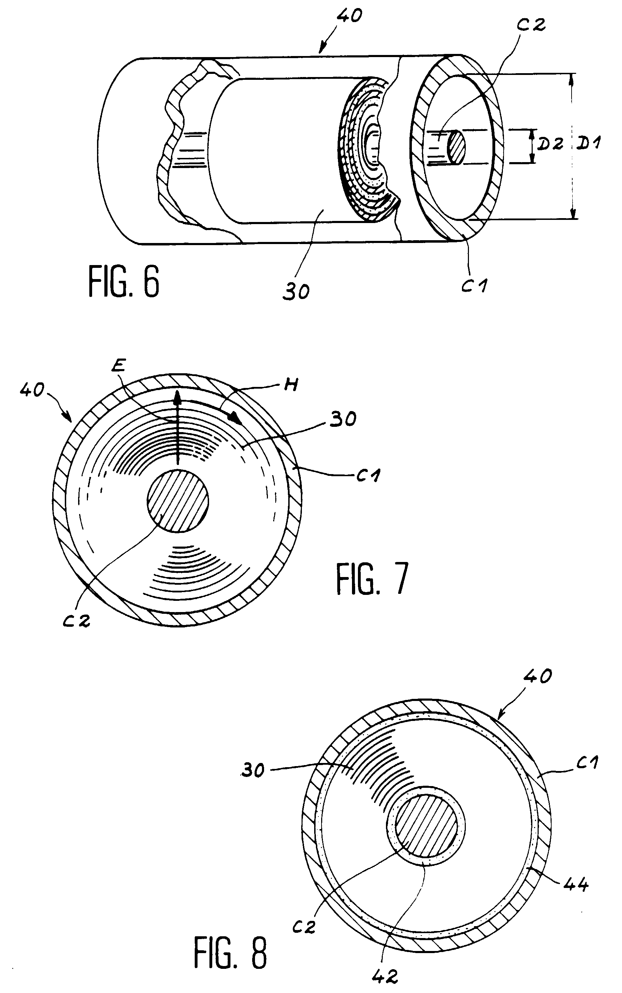

Le tore 30 ainsi constitué est placé ensuite dans une ligne coaxiale 40, comme illustré sur la figure 6. Cette ligne est formée d'un conducteur extérieur C1 (dont le diamètre intérieur est D1) et d'un conducteur intérieur C2 (dont le diamètre extérieur est D2).

La figure 7 montre, en coupe, le tore 30 dans la ligne coaxiale 40 et permet de voir que les lignes de champ magnétique H de l'onde circulant dans la ligne coaxiale (onde TEM) sont bien situées dans les couches ferromagnétiques, alors que les lignes de champ électrique E sont normales à ces couches.

Si l'on souhaite récupérer le ruban, on peut bobiner autour d'une bobine évidée en son centre sur un diamètre D2 et réalisée avec un matériau diélectrique, jusqu'à atteindre un diamètre légèrement inférieur ou égal au diamètre D1 du conducteur extérieur de la ligne coaxiale. L'extrémité libre du ruban peut être maintenue soit par collage, soit par enserrage dans un collier réalisé en diélectrique, soit par un dispositif mécanique réalisé en matériau électrique dont le diamètre atteindra le diamètre D1 du conducteur extérieur. C'est ce qui est représenté sur la figure 8 où l'on voit une bobine évidée 42 et un collier de serrage 44.

Si l'épaisseur de la bobine 42 est très faible devant le quotient de la longueur d'onde dans le vide (à la fréquence de travail) par l'indice du matériau à cette fréquence, et si, de même, l'écart de diamètre entre la ligne coaxiale et l'extérieur du tore ferromagnétique est faible devant la longueur d'onde (éventuellement divisée par l'indice du collier de serrage), alors on peut réaliser les mesures comme indiqué précédemment, à condition de définir F non plus comme la fraction volumique de matériau ferromagnétique, mais comme la fraction linéique de ferromagnétique sur la portion du rayon qui va du conducteur intérieur de la ligne coaxiale à son conducteur extérieur.

Le procédé de l'invention s'applique aussi au cas où les couches minces en matériau ferromagnétique présentent un axe de facile aimantation et un axe de difficile aimantation. Dans ce cas, après avoir déposé la couche mince en matériau ferromagnétique sur le film isolant, on découpera l'ensemble parallèlement à l'un desdits axes d'aimantation pour constituer le ruban.

On peut aussi utiliser les couches ferromagnétiques en présence d'un champ magnétique continu. Dans ce cas, la mesure en ligne coaxiale s'effectuera elle aussi en présence d'un champ magnétique. Ces champs peuvent être obtenus par exemple au moyen d'aimants permanents ou d'enroulements conducteurs.

Un exemple de mise en oeuvre du procédé de l'invention va maintenant être décrit. On dépose une couche de CoNiZrMo d'épaisseur 0,4 μm sur un film souple de Mylar (marque déposée) d'épaisseur 12 μm. On détermine par effet KERR les directions de facile et de difficile aimantation. On découpe un ruban de largeur 3 mm, de plusieurs dizaines de centimètres de long. On bobine ce ruban autour d'un axe, à l'aide d'une colle Araldite (marque déposée) afin d'obtenir un tore rigide. Par usinage on rectifie ce tore aux dimensions nécessaires pour le passage dans la ligne de mesure coaxiale, en prenant bien soin de ne pas induire de court-circuit sur les faces. On détermine le taux de charge en matériau ferromagnétique, soit directement si l'on connaît l'épaisseur de colle, soit par mesure de densité, soit encore par mesure d'aimantation. Dans l'exemple considéré, ce taux est de 3%.

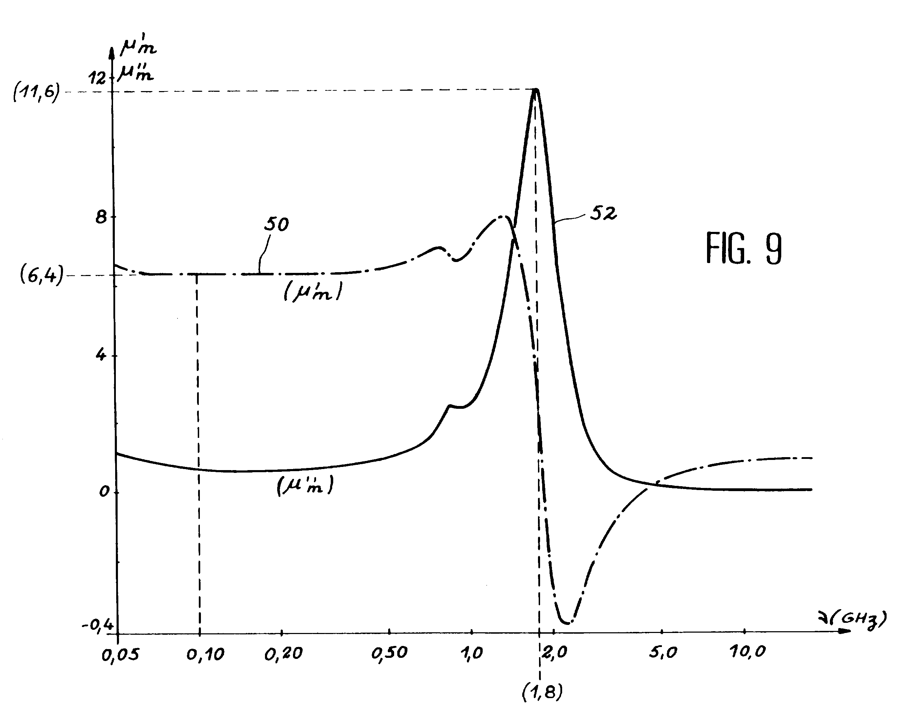

On mesure les deux composantes de la perméabilité magnétique, soit $\mu'$ (composante réelle) et $\mu''$ (composante imaginaire), à l'aide d'un banc de mesure HEWLETT PACKARD de type "HP 8510 Network Analyser". On obtient les résultats de la figure 9 où la courbe 50 correspond à la composante $\mu'$ et la courbe 52 à la composante $\mu''$. En abscisses est portée la fréquence de mesure $\nu$, qui va de 0,05 GHz à 18 GHz.

Comme l'épaisseur de la couche ferromagnétique est nettement plus faible que l'épaisseur de peau aux fréquences considérées, on peut appliquer la plus simple des formules données plus haut, à savoir :

$$\mu_f = 1 + (\mu_m - 1)/F$$

avec F = 0,03.

A une fréquence de 100 MHz (ainsi d'ailleurs que dans une plage allant de 100 à 500 MHz), le graphique de la figure 9 donne pour $\mu'_m$ la valeur 6,4. La partie $\mu'_f$ du ferromagnétique vaut donc 1 + (6,4-1)/0,03 soit 180 environ. Quant à la composante $\mu''_m$, elle vaut, à son maximum, (obtenu pour 1,8 GHz) 11,6. D'où une composante $\mu''_f$ du ferromagnétique égale à 11,6/0,03 soit 390 environ.

On peut observer que le banc de mesure hyperfréquences donne accès non seulement à la perméabilité magnétique mais aussi à la permittivité électrique du composite pour une direction du champ électrique.

Le procédé de l'invention ne se limite pas au cas où les éléments ferromagnétiques sont des couches minces, mais s'applique également au cas de fils, fibres ferromagnétiques, plaquettes ou aiguilles.

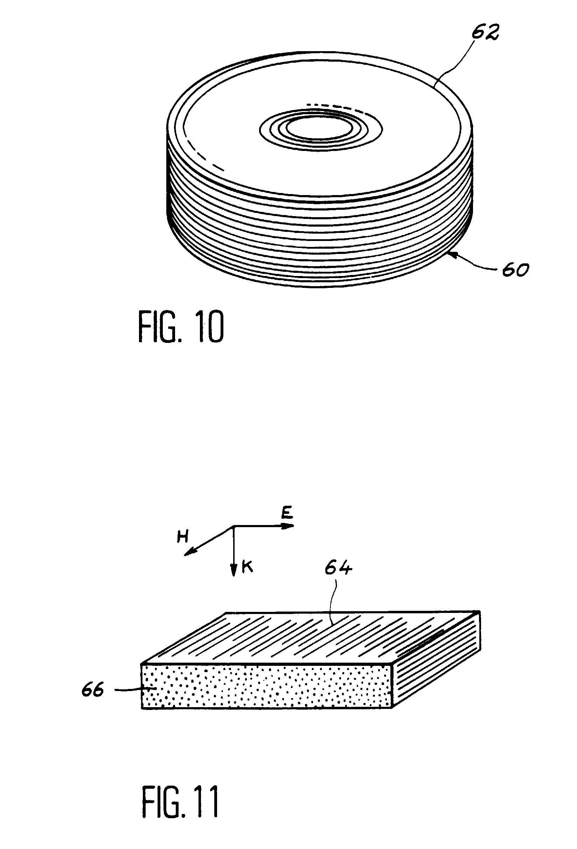

La première étape du procédé consiste dans ce cas à bobiner le fil ferromagnétique pour constituer un tore, comme illustré sur la figure 10 sous la référence générale 60, le fil étant référencé 62. Le fil est avantageusement noyé dans un matériau isolant comme une résine ou une colle (cas des plaquettes ou aiguilles).

Le fil peut être ferromagnétique en soi, ou être obtenu par dépôt d'une couche ferromagnétique sur un fil isolant. Dans ce cas, comme pour la couche mince, le revêtement ferromagnétique du fil est de préférence interrompu par endroits et n'est pas d'un seul tenant pour que le calcul de la perméabilité corresponde le plus exactement possible au modèle du composite que l'on a en vue.

Dans le cas de fibres, le composite a l'allure illustrée sur la figure 11. Les fibres ferromagnétiques 64 sont allongées dans un isolant 66. Les fibres sont toutes allongées dans une même direction. Le tore de la figure 10 permet de connaître les propriétés du matériau de la figure 11, pour la polarisation de l'onde représentée sur la figure 11 (ceci dans le cas bien entendu où le fil, l'isolant et le taux de charge sont les mêmes pour les matériaux des figures 10 et 11).

**Revendications**

1. Procédé de détermination de la perméabilité magnétique intrinsèque d'éléments ferromagnétiques ayant une forme allongée selon au moins une direction, caractérisé par le fait que :

   - on bobine ces éléments (22, 62) sous forme d'un tore (30, 60), en les enrobant dans un matériau isolant électrique, lesdits éléments (22, 62) étant allongés dans le tore dans une direction sensiblement tangentielle,
   - on dispose ce tore dans une ligne coaxiale (40),
   - on mesure la perméabilité magnétique ($\mu_m$) du tore (30,60),
   - on déduit de la perméabilité magnétique ($\mu_m$) ainsi mesurée et de la fraction (F) de matériau ferromagnétique contenue dans le tore, la perméabilité magnétique intrinsèque ($\mu_f$) desdits éléments ferromagnétiques.

2. Procédé selon la revendication 1, dans lequel les éléments ferromagnétiques dont on veut déterminer la perméabilité magnétique sont des couches minces (22), caractérisé par le fait que, pour former le tore (30) :

   - on part d'un film isolant électriquement (20),
   - on recouvre ce film isolant (20) d'une couche mince de matériau ferromagnétique (22),
   - on découpe le support isolant ainsi recouvert pour former un ruban,
   - on bobine ce ruban sur lui-même.

3. Procédé selon la revendication 2, caractérisé par le fait que, lors du bobinage du ruban, on ajoute un matériau, genre colle ou résine ou vernis.

4. Procédé selon la revendication 2, caractérisé par le fait qu'avant le bobinage du ruban, on forme des coupures (24) dans la couche ferromagnétique (22).

5. Procédé selon la revendication 4, caractérisé par le fait qu'on forme les coupures (24) de la couche ferromagnétique (22) au moment du dépôt de cette couche (22) sur le film isolant (20), par masquage d'une zone du film (20).

6. Procédé selon la revendication 4, caractérisé par le fait qu'on forme les coupures (24) de la couche ferromagnétique (22) après dépôt de cette couche sur le film isolant (20), par gravure de la couche ferromagnétique (22).

7. Procédé selon la revendication 4, caractérisé par le fait qu'on forme les coupures (24) de la couche ferromagnétique (22) après dépôt de cette couche, par étirement du film isolant (20) jusqu'à fractionnement de la couche ferromagnétique (22).

8. Procédé selon la revendication 2, dans lequel les couches minces (22) en matériau ferromagnétique présentent un axe de facile aimantation et un axe de difficile aimantation, caractérisé par le fait qu'après avoir déposé la couche mince en matériau ferromagnétique (22) sur le film isolant (20) on découpe l'ensemble parallèlement à l'un desdits axes d'aimantation pour constituer le ruban.

9. Procédé selon la revendication 1, dans lequel les éléments ferromagnétiques dont on veut déterminer la perméabilité magnétique sont des couches minces (22), caractérisé par le fait que, pour former le tore (30) :

   - on part d'un ruban ferromagnétique,
   - on recouvre ce ruban d'un isolant,
   - on bobine l'ensemble sur lui-même.

10. Procédé selon la revendication 1, dans lequel les éléments dont on veut déterminer la perméabilité magnétique sont des fils ferromagnétiques (62), caractérisé par le fait que, pour former le tore (60), on bobine un fil ferromagnétique (62) sur une âme en enrobant l'ensemble dans un matériau isolant.

11. Procédé selon la revendication 10, caractérisé par le fait que pour constituer le fil ferromagnétique (62), on part d'un fil isolant et on dépose sur ce fil un matériau ferromagnétique.

12. Procédé selon la revendication 1, dans lequel les éléments dont on veut déterminer la perméabilité magnétique sont des plaquettes ou des aiguilles, caractérisé par le fait que, pour former le tore (60) :

- on mélange lesdits éléments avec un liant,
- on réalise une couche de faible épaisseur de ce mélange dans laquelle les éléments sont orientés,
- on découpe un ruban dans cette couche,
- on bobine ce ruban.

13. Procédé selon la revendication 12, caractérisé par le fait que pour orienter les éléments dans la couche, on applique à cette couche un champ magnétique de direction appropriée.

14. Procédé selon la revendication 12, caractérisé par le fait qu'on utilise un liant qui reste souple après sa prise.

15. Procédé selon la revendication 12, caractérisé par le fait que l'on ajoute de la colle ou de la résine lors du bobinage.

16. Procédé selon l'une quelconque des revendications 1 à 15, caractérisé par le fait qu'on détermine la perméabilité magnétique de l'élément ferromagnétique ($\mu_f$) à partir de la perméabilité mesurée ($\mu_m$) du tore par la relation

$$\mu_f = 1 + (\mu_m - 1)/F$$

où F est le taux de charge du tore en matériau ferromagnétique.

17. Procédé selon l'une quelconque des revendications 1 à 16, dans lequel la ligne coaxiale (40) étant constituée d'un conducteur extérieur (C1) ayant un certain diamètre intérieur (D1) et d'un conducteur intérieur (C2) ayant un certain diamètre extérieur (D2), caractérisé par le fait qu'on réalise un tore (30) dont le diamètre extérieur est légèrement inférieur au diamètre intérieur (D1) du conducteur extérieur (C1), et dont le diamètre intérieur est légèrement supérieur au diamètre extérieur (D2) du conducteur intérieur (C2), le tore (30) étant d'une part bobiné sur une bobine en diélectrique (42) évidée en son centre et disposée entre le conducteur intérieur (C2) de la ligne coaxiale (40) et le tore (30), et, d'autre part, introduit dans un collier diélectrique (44) s'ajustant entre le tore (30) et le conducteur extérieur (C1) de la ligne coaxiale (40).

## Patentansprüche

1. Verfahren zur Bestimmung der intrinsischen magnetischen Permeabilität von feromagnetischen Elementen, die eine in wenigstens einer Richtung langgestreckte Form aufweisen,
   **dadurch gekennzeichnet :**

   - daß man diese Elemente (22, 62) in Form eines Torus (30, 60) aufspult, indem man sie mit einem elektrisch isolierenden Material umhüllt, wobei besagte Elemente (22, 62) sich in dem Torus in einer im wesentlichen tangentialen Richtung erstrecken,
   - daß man diesen Torus in einer Koaxialleitung (40) anordnet,
   - daß man die magnetische Permeabilität ($\mu_m$) des Torus (30, 60) mißt,
   - daß man von der so gemessenen magnetischen Permeabilität ($\mu_m$) und von dem in dem Torus enthaltenen Anteil (F) ferromagnetischen Materials die intrinsische magnetische Permeabilität ($\mu_f$) besagter ferromagnetischer Elemente ableitet.

2. Verfahren nach Anspruch 1, bei dem die ferromagnetischen Elemente, deren magnetische Permeabilität bestimmt werden soll, dünne Schichten (22) sind,
   dadurch gekennzeichnet, daß, um den Torus (30) zu bilden:

   - man ausgeht von einem elektrisch isolierenden Film (20),
   - man diesen isolierenden Film (20) mit einer dünnen Schicht aus ferromagnetischem Material (22) überzieht,
   - man den so überzogenen Träger zuschneidet, um einen Streifen zu bilden,
   - man diesen Streifen auf sich selbst aufspult.

3. Verfahren nach Anspruch 2, dadurch gekennzeichnet, daß man beim Aufspulen dieses Streifens ein Material von der Art eines Klebstoffs, Harzes oder Lacks hinzufügt.

4. Verfahren nach Anspruch 2, dadurch gekennzeichnet, daß man vor dem Aufspulen des Streifens in der ferromagnetischen Schicht (22) Unterbrechungen (24) ausbildet.

**5.** Verfahren nach Anspruch 4, dadurch gekennzeichnet, daß man die Unterbrechungen (24) der ferromagnetischen Schicht (22) zum Zeitpunkt der Abscheidung dieser Schicht (22) auf dem isolierenden Film (20) durch Maskierung einer Zone des Films (20) bildet.

**6.** Verfahren nach Anspruch 4, dadurch gekennzeichnet, daß man die Unterbrechungen (24) der ferromagnetischen Schicht (22) nach Abscheidung dieser Schicht auf dem isolierenden Film (20) durch Ätzung der ferromagnetischen Schicht bildet.

**7.** Verfahren nach Anspruch 4, dadurch gekennzeichnet, daß man die Unterbrechungen (24) der ferromagnetischen Schicht (22) nach Abscheidung dieser Schicht durch Auseinanderziehen bzw. Strecken des isolierenden Films (20) bis zur Zersplitterung der ferromagnetischen Schicht (22) bildet.

**8.** Verfahren nach Anspruch 2, bei dem die dünnen Schichten (22) aus ferromagnetischem Material eine Achse der leichten Magnetisierung und eine Achse der schwierigen Magnetisierung aufweisen, dadurch gekennzeichnet, daß man nach dem Abscheiden der dünnen Schicht aus ferromagnetischen Material (22) auf dem isolierenden Film (20) das Ganze parallel zu einer der genannten Magnetisierungsachsen durchschneidet, um den Streifen zu bilden.

**9.** Verfahren nach Anspruch 1, bei dem die ferromagnetischen Elemente, deren magnetische Permeabilität bestimmt werden soll, dünne Schichten (22) sind,
dadurch gekennzeichnet, daß, um den Torus (30) zu bilden:

- man von einem ferromagnetischen Streifen ausgeht,
- man diesen Streifen mit einem Isoliermaterial überzieht,
- man das Ganze auf sich selbst aufspult.

**10.** Verfahren nach Anspruch 1, bei dem die Elemente, deren magnetische Permeabilität bestimmt werden soll, ferromagnetische Drähte (62) sind,
dadurch gekennzeichnet, daß man, um den Torus (60) zu bilden, einen ferromagnetischen Draht (62) auf einen Kern spult, wobei man das Ganze mit einem isolierenden Material umhüllt.

**11.** Verfahren nach Anspruch 10, dadurch gekennzeichnet, daß man, um diesen ferromagnetischen Draht (62) herzustellen, ausgeht von einem isolierenden Draht und man auf diesem Draht ein ferromagnetisches Material abscheidet.

**12.** Verfahren nach Anspruch 1, bei dem die Elemente, deren magnetische Permeabilität bestimmt werden soll, Plättchen oder Nadeln sind, dadurch gekennzeichnet, daß, um den Torus (60) zu bilden:

- man besagte Elemente mit einem Bindemittel mischt,
- man eine Schicht geringer Dicke dieser Mischung herstellt, in der die Elemente ausgerichtet werden,
- man aus dieser Schicht einen Streifen schneidet,
- man diesen Streifen aufspult.

**13.** Verfahren nach Anspruch 12, dadurch gekennzeichnet, daß man, um die Elemente in der Schicht auszurichten, diese Schicht einem Magnetfeld mit entsprechender Richtung aussetzt.

**14.** Verfahren nach Anspruch 12, dadurch gekennzeichnet, daß man ein Bindemittel verwendet, daß nach seiner Abbindung weich bleibt.

**15.** Verfahren nach Anspruch 12, dadurch gekennzeichnet, daß man beim Aufspulen Klebstoff oder Harz hinzufügt.

**16.** Verfahren nach einem der Ansprüche 1 bis 15, dadurch gekennzeichnet, daß man die magnetisches Permeabilität des ferromagnetischen Elements ($\mu_f$) bestimmt aufgrund der gemessenen Permeabilität ($\mu_m$) des Torus durch die Relation

$$\mu_f = 1 + (\mu_m-1)/F$$

wobei F der Füllgrad des Torus mit ferromagnetischem Material ist.

17. Verfahren nach einem der Ansprüche 1 bis 16, bei dem die Koaxialleitung (40) gebildet wird durch einen Außenleiter (C1) mit einem bestimmten Innendurchmesser (D1) und einen Innenleiter (C2) mit einem bestimmten Außendurchmesser (D2),

dadurch gekennzeichnet, daß man einen Torus (30) herstellt, dessen Außendurchmesser etwas kleiner ist als der Innendurchmesser (D1) des Außenleiters (C1), und dessen Innendurchmesser etwas größer ist als der Außendurchmesser (D2) des Innenleiters (C2), wobei der Torus (30) einerseits auf eine hohle Rolle aus Dielektrikum (42) gespult wird, die sich zwischen dem Innenleiter (C2) der Koaxialleitung (40) und dem Torus (30) befindet, und andererseits in einen dielektrischen Ring (44) hineingeschoben wird, der zwischen den Torus (30) und den Außenleiter (C1) der Koaxialleitung (40) hineinpaßt.

## Claims

1. Process for the determination of the intrinsic magnetic permeability of ferromagnetic elements having an elongated shape in at least one direction, characterized in that:

   - these elements (22, 62) are wound in the form of a torus (30, 60), coated in an electrically insulating material, said elements (22, 62) being elongated in the torus in a substantially tangential direction,
   - said torus is placed in a coaxial line (40),
   - the magnetic permeability ($\mu$m) of the torus (30, 60) is measured,
   - from the magnetic permeability ($\mu$m) measured in this way and the ferromagnetic material fraction (F) contained in the torus is deduced the intrinsic magnetic permeability ($\mu$f) of said ferromagnetic elements.

2. Process according to claim 1, in which the ferromagnetic elements whose magnetic permeability is to be determined are thin layers (22), characterized in that, for forming the torus (30):

   - the starting article is an electrically insulating film (20),
   - said insulating film (20) is covered with a thin ferromagnetic material layer (22),
   - the thus covered insulating support is cut in order to form a tape,
   - said tape is wound onto itself.

3. Process according to claim 2, characterized in that, during the winding of the tape, a material such as an adhesive, resin or varnish is added.

4. Process according to claim 2, characterized in that prior to the winding of the tape, cuts (24) are made in the ferromagnetic layer (22).

5. Process according to claim 4, characterized in that the cuts (24) in the ferromagnetic layer (22) are formed at the time of depositing said layer (22) on the insulating film (20) by masking one area of the film (20).

6. Process according to claim 4, characterized in that the cuts (24) in the ferromagnetic layer (22) are formed after the deposition of said layer on the insulating film (20), by etching the ferromagnetic layer (22).

7. Process according to claim 4, characterized in that the cuts (24) in the ferromagnetic layer (22) are formed after depositing said layer, by stretching the insulating film (20) until the ferromagnetic layer (22) splits.

8. Process according to claim 2, in which the thin ferromagnetic material layers (22) have an easy magnetization axis and a difficult magnetization axis, characterized in that after depositing the thin ferromagnetic material layer (22) on the insulating film (20), the assembly is cut parallel to one of said magnetization axes in order to form the tape.

9. Process according to claim 1, in which the ferromagnetic elements whose magnetic permeability is to be determined are thin layers (22), characterized in that, for forming the torus, the starting product is a ferromagnetic tape, said tape is covered with an insulator and the assembly is wound onto itself.

**10.** Process according to claim 1, in which the elements whose magnetic permeability is to be determined are ferromagnetic wires (62), characterized in that, for forming the torus (60), a ferromagnetic wire (62) is wound onto a core, the assembly being coated with an insulating material.

**11.** Process according to claim 10, characterized in that for forming the ferromagnetic wire (62), the starting product is an insulating wire and on the latter is deposited a ferromagnetic material.

**12.** Process according to claim 1, in which the elements whose magnetic permeability is to be measured are wafers or needles, characterized in that, for forming the torus (60):

- said elements are mixed with a binder,
- a layer of limited thickness of said mixture is formed and in which the elements are oriented,
- a tape is cut in said layer,
- said tape is wound.

**13.** Process according to claim 12, characterized in that for orienting the elements in the layer, to the latter is applied a magnetic field with an appropriate direction.

**14.** Process according to claim 12, characterized in that use is made of a binder which remains flexible after setting.

**15.** Process according to claim 12, characterized in that adhesive or resin is added during winding.

**16.** Process according to one of the claims 1 to 15, characterized in that the magnetic permeability of the ferromagnetic element ($\mu f$) from the measured permeability ($\mu m$) of the torus is determined by the relation:

$$\mu f = 1 + (\mu m-1)/F$$

in which F is the charge rate of the ferromagnetic material torus.

**17.** Process according to one of the claims 1 to 16, in which the coaxial line (40) is constituted by an external conductor (C1) having a certain internal diameter (D1) and an internal conductor (C2) having a certain external diameter (D2), characterized in that a torus (30) is formed, whose external diameter is slightly smaller than the internal diameter (D1) of the external conductor (C1) and whose internal diameter slightly exceeds the external diameter (D2) of the internal conductor (C2), the torus (30) being on the one hand wound onto a dielectric coil (42), which is recessed in its centre and placed between the internal conductor (C2) of the coaxial line (40) and the torus (30) and on the other hand is introduced into a dielectric collar (44) fitted between the torus (30) and the external conductor (C1) of the coaxial line (40).

FIG. 1

FIG. 2

FIG. 3

FIG. 4

FIG. 5

FIG. 6

FIG. 7

FIG. 8

FIG. 9

EP 0 674 771 B1

FIG. 10

FIG. 11